# EUROPÄISCHE PATENTANMELDUNG

(11) **EP 2 190 276 A2**
(43) Veröffentlichungstag der Anmeldung: **26.05.2010**
(21) Anmeldenummer: 09014614.3
(22) Anmeldetag: 24.11.2009
(51) Int. Cl.: H05K 7/20

(54) **Einrichtung und Verfahren zum Kühlen des Innenraums eines Elektronikschrankes**

(30) Priorität: 24.11.2008 DE 102008058784
(71) Anmelder: Hilmar, Lukas, 01731 Kreischa (DE)
(72) Erfinder: Hilmar, Lukas, 01731 Kreischa (DE)
(74) Vertreter: Pätzelt, Peter

(57) **Zusammenfassung**

Die Erfindung betrifft eine Einrichtung zum Kühlen des Innenraums eines Elektronikschrankes (1) mit einer Kühleinrichtung, bestehend aus einer Kälteanlage (8), deren Verdichter (13) und Verflüssiger (14) außerhalb und deren Verdampfer (7) innerhalb des Elektronikschrankes (1) vorgesehen sind, sowie mit einer Vorrichtung zum Umwälzen der Raumluft. Der Verdampfer (7) ist von einem Kühlkanal umschlossen, in der Kältemittelleitung zum Verdampfer (7) ist ein Ventil (24) mit einer Betätigungseinrichtung (25) angeordnet und die Betätigungseinrichtung (25) ist mit einer digitalen Regeleinheit (29) zur Regelung der Kühlleistung verbunden. Verfahrennsgemäß wird die Temperatur am Kältemitteleingang und -ausgang sowie an weiteren Punkten am Verdampfer (7) und/oder die aktuelle Taupunkttemperatur gemessen und die jeweiligen Messwertsignale auf der Grundlage der technologisch vorgegebene Prozessdaten sowie der Messwertsignale wird die aktuell erforderliche Kälteleistung ermittelt. Die Betätigungseinrichtung (25) am Ventil (24) wird derart gesteuert, dass die erforderliche Menge eines Kältemittels dem Verdampfer (7) zugeführt wird.

## Beschreibung

### Anwendungsgebiet der Erfindung

Die Erfindung betrifft eine Einrichtung und ein Verfahren zum Kühlen des Innenraums eines räumlich geschlossenen Elektronikschrankes mit darin angeordnet mindestens einer elektronischen oder elektrischen Wärmequelle und mindestens einer Kühleinrichtung sowie einer Vorrichtung zum Umwälzen der Raumluft. Derartige Einrichtungen können insbesondere für Elektronikschränke mit Servern und entsprechend hohen Verlustleistungen eingesetzt werden.

### Hintergrund der Erfindung

Nach dem Stand der Technik sind zum Kühlen des Innenraumes von Elektronikschränken allgemein zwei Verfahren und entsprechende Einrichtungen bekannt. Zum einen ist das die Luftkühlung und zum anderen die Kühlung durch Umluft, die von einem wassergekühlten Kühlaggregat gekühlt wird. Der aktuelle Stand der Technik ist im Aufsatz "Effiziente Elektronischrank-Klimatisierung", A. Pallasch, Anergie 2.0 Kompendium 2008 / www.Energy20.net, umfassend beschrieben. Dargelegt wird u.a. die Kühlung von Server-Schränken von 25 kW bis 40 kW Verlustleistung. Danach wird die reine Luftkühlung immer mehr durch die Kühlung mit Luft-Wasser-Wärmetauschern verdrängt.

In der DE 32 40 124 C wird ein Kühlgerät mit einem Kälteaggregat für einen isolierten Kühlraum für zu kühlende Gegenstände beschrieben. Der Kühlraum ist wärmeisoliert ausgeführt und nach einem unten vorgesehenen Maschinenraum mittels einer demontierbaren Isolierplatte abgetrennt. Die Baugruppen Kompressor und Verflüssiger des Kühlaggregates sind im Maschinenraum und der Verdampfer als Lammellenverdampfer ist innerhalb des Kühlraumes angeordnet. Ein Querstromlüfter wälzt die Raumluft im Kühlraum durch den Lammellenverdampfer hindurch um.

Die DE 100 08 383 A1 gibt einen Schaltschrank oder -gehäuse mit einer Klimatisierungseinrichtung an, die ein Kältekreislaufsystem mit einem Verdampfer und einem Verflüssiger aufweist, wobei dem Verdampfer ein Luftinnenkreislauf zugeordnet ist, der mit dem Schaltschrank-Innenraum in räumlicher Verbindung steht. Ein Lüfter fördert Luft durch den Innenraum des Schaltschrankes. Der Verflüssiger steht mit den übrigen Komponenten des Kältekreislaufes über Kühlmittelleitungen in Verbindung. Der Verdampfer ist zusammen mit einem Lüfter in eine Verdampfereinheit integriert, die am Schaltschrank angeordnet ist. Der Verflüssiger ist zusammen mit einem Lüfter in einer Verflüssigereinheit integriert und die Verflüssigereinheit ist räumlich getrennt von der verdampfereinheit und räumlich getrennt von dem Schaltschrank angeordnet.

Die Lösungen des Standes der Technik erweisen sich in der Praxis vielfach als sehr problemetisch. Luftkühlungen erfordern einen sehr hohen Luftumsatz mit den Folgen, dass Staub aufgewirbelt wird und, insbesondere bei Elektronikschränken mit höherer Verlustleistung in Form von Wärme, die die elektronischen Einrichtungen stark beeinträchtigt werden können. Bei Wasser-Luftkühlungen kommt zusätzlich das Problem hinzu, dass ein möglicher Wasseraustritt zu einer erheblichen Havarie führen kann. Ein weiteres Problem besteht darin, dass die aus den Elektronikschränken abzuführende Wärme die Umgebungsräume stark erwärmt oder zur Abführung der Wärme nach außen große Rohrquerschnitte erforderlich sind. Bei Schaltschränken mit einem Kältekreislauf besteht die Gefahr von Kondensatbildung mit Folgeschäden, indem die zu kühlenden Elemente durch das Kondensat geschädigt werden.

### Zusammenfassung der Erfindung

Ausgehend vom bekannten Stand der Technik liegt der Erfindung die Aufgabe zugrunde, eine Einrichtung und ein verfahren zum wirksamen Kühlen des Innenraums eines Elektronikschrankes mit einem Kältekreislauf anzugeben, mit denen auch größere Wärmemengen abgeführt werden können, ohne dass die zu kühlenden Elemente geschädigt werden und die Umgebungstemperatur wesentlich erhöht wird.

Die Erfindung löst die Aufgabe für die Einrichtung durch die im Anspruch 1 angegebenen Merkmale. Vorteilhafte Weiterbildungen der Erfindung sind in den Unteransprüchen gekennzeichnet und werden nachstehend zusammen mit der Beschreibung der bevorzugten Ausführung der Erfindung, einschließlich der Zeichnung, näher dargestellt. Die Aufgabe für das Verfahren wird durch die Merkmale des Anspruchs 9 gelöst.

Die erfindungsgemäße Einrichtung zum Kühlen des Innenraums eines räumlich geschlossenen Elektronikschrankes, mit mindestens einer, z.B. in Elektronikeinschüben o.ä. Halterungen angeordneten, elektronischen oder elektrischen Wärmequelle, umfasst mindestens eine Kühleinrichtung, bestehend aus einer Kälteanlage, deren Verdichter und Verflüssiger außerhalb des Elektronikschrankes angeordnet sind und deren Verdampfer innerhalb des Elektronikschrankes vorgesehen ist, wobei der Verdampfer mit dem Verdichter und dem Verflüssiger durch Kältemittelleitungen verbunden ist. Zugehörig ist weiter eine Vorrichtung zum Umwälzen der Raumluft innerhalb des Elektronikschrankes.

Erfindungsgemäß ist der Verdampfer von einem Kühlkanal umschlossen, derart dass die umgewälzte Raumluft im Elektronikschrank innerhalb des Kühlkanals unmittelbar mit den Kühlflächen des Verdampfers in Berührung kommt. In der Kältemittelleitung zum Verdampfer ist ein Ventil mit einer Betätigungseinrichtung angeordnet, die mit einer digitalen Regeleinheit zur Regelung der Kühlleistung verbunden ist.

Zur wirkungsvollen Umwälzung der Raumluft im Innenraum des räumlich geschlossenen Elektronikschrankes zum Kühlen der darin angeordneten elektronischen und/oder elektrischen Wärmequellen können als bekannte und geeignete Leiteinrichtungen und Gebläse vorhanden sein.

Nach Anspruch 2 ist am Ausgang des Kühlkanals um den Verdampfer mindestens ein Lüfter vorhanden und derart in den Kreislauf der umwälzenden Raumluft eingebunden, dass diese aus dem Kühlkanal als gekühlte Luft ausströmt, durch die Elektronikeinschübe hindurch strömt und danach als erwärmte Luft am Eingang des Kühlkanals wieder in den Kühlkanal einströmt, wobei dem Lüfter in Strömungsrichtung nachgeordnet eine Rückschlagklappe derart zugeordnet ist, dass die Raumluft ausschließlich in der vorgesehenen Richtung strömen kann.

Die digitale Regeleinheit zur Regelung der Kühlleistung ist mit einem elektronischen Speicher für technologisch vorgegebenen Prozessdaten ausgerüstet und mit einer Vielzahl von Signalgebern am Verdampfer verbunden, deren Signalgeber mit der digitalen Regeleinheit gekoppelt sind.

In vorteilhafter Weise sind am Verdampfer im Bereich des Kältemitteleinganges und des Kältemittelausganges sowie im mittleren Bereich Temperaturmessfühler vorhanden. Von besonderer Bedeutung ist ein im oberen Bereich des Elektronikschrankes vorgesehener Taupunktfühler. Weiterhin sind am Lufteintritt und am Luftaustritt des Kühlkanals Temperaturmessfühler vorgesehen.

Der Verdampfer kann in eine Vielzahl von Verdampfersegmenten mit je einem Kältemitteleingang und je einem Kältemittelausgang unterteilt sein, wobei zwischen dem Ventil und dem Verdampfer ein Kältemittelverteiler mit einer entsprechenden Vielzahl von Ausströmleitungen vorhanden ist und jeder Kältemitteleingang mit je einer Ausströmleitung verbunden ist. Die Kältemittelausgänge der Verdampfersegmente können mit einer Kältemittel-Sammelleitung verbunden sein.

Das Verfahren zum Kühlen des Innenraums eines räumlich geschlossenen Elektronikschrankes mit darin angeordneten elektronischen und/oder elektrischen Wärmequellen betrifft einen Elektronikschrank mit mindestens einer Kühleinrichtung, bestehend aus einer Kälteanlage, deren Verdichter und Verflüssiger außerhalb und deren Verdampfer innerhalb des Elektronikschrankes vorgesehen ist, wobei der Verdampfer mit dem Verdichter und dem Verflüssiger durch Kältemittelleitungen verbunden ist und in der Kältemittelleitung zum Verdampfer ein Ventil mit einer Betätigungseinrichtung vorgesehen ist, sowie einer Vorrichtung zum Umwälzen der Raumluft und einer digitalen Regeleinheit zur Regelung der Kühlleistung der Kühleinrichtung mit einem elektronischen Speicher für technologisch vorgegebenen Prozessdaten.

Verfahrensgemäß wird die Temperatur im Bereich des Kältemitteleinganges und des Kältemittelausganges sowie an einer Vielzahl von weiteren Punkten am Verdampfer, und/oder die Temperatur der umgewälzten Raumluft im Elektronikschrank in Strömungsrichtung vor und hinter dem Verdampfer und/oder die aktuelle Taupunkttemperatur im oberen Bereich des Elektronikschrankes gemessen und die jeweiligen Messwertsignale der digitalen Regeleinheit zugeführt. In der Regeleinheit wird auf der Grundlage der technologisch vorgegebene Prozessdaten sowie der Messwertsignale die aktuell erforderliche Kälteleistung ermittelt und die Betätigungseinrichtung am Ventil derart gesteuert, dass die erforderliche Menge eines Kältemittels dem Verdampfer zugeführt wird.

Der Vorteil der Erfindung besteht insbesondere darin, dass die Kühlung der elektronischen und/oder elektrischen Wärmequellen im Elektronikschrank geregelt und sehr intensiv erfolgen kann, ohne das es zur Bildung von unerwünschtem Kondensat kommt.

### Kurze Beschreibung der Zeichnungen

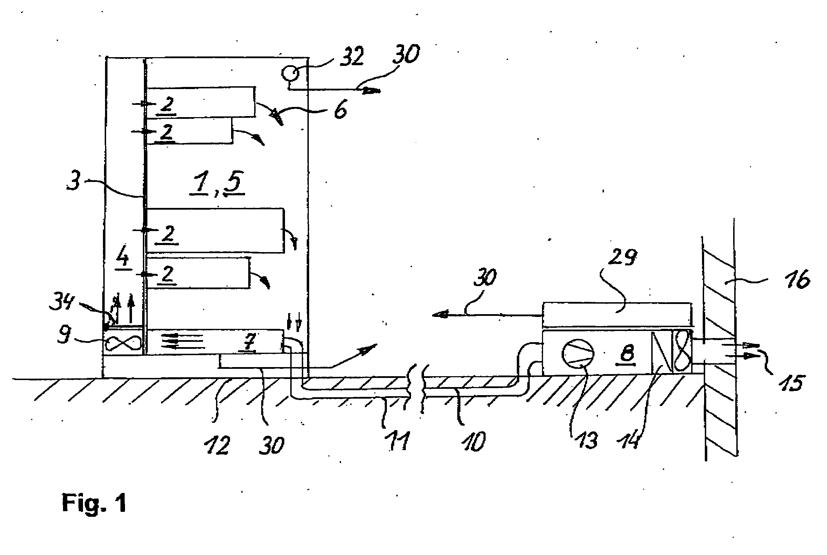

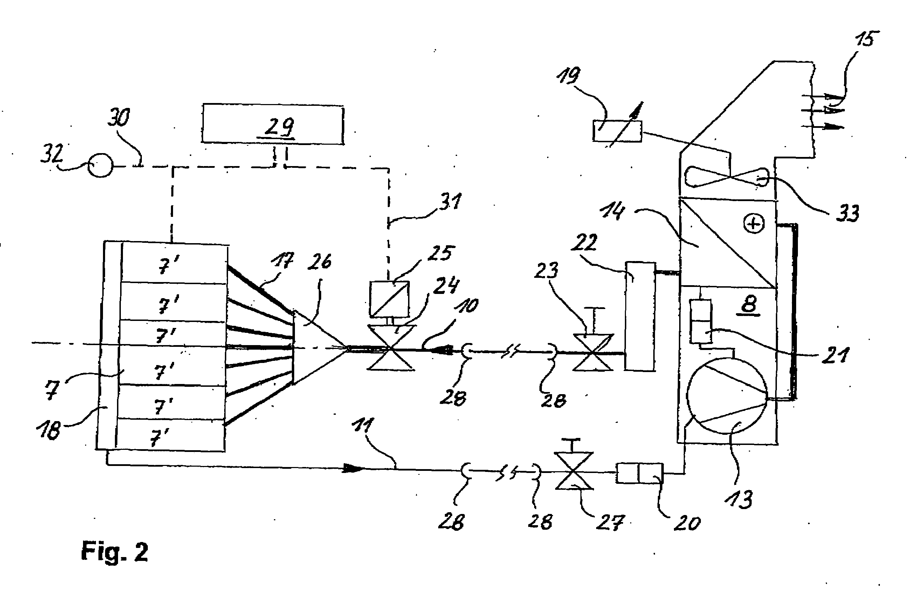

Die Erfindung wird nachstehend an einem Ausführungsbeispiel näher erläutert. Zugehörig zeigt Figur 1 eine Schnittzeichnung durch einen Elektronikschrank mit der erfindungsgemäßen Einrichtung zum Kühlen dessen Innenraumes. Figur 2 zeigt zugehörige zur Anordnung nach Figur 1 das Schaltschema der Einrichtung.

### Beschreibung einer bevorzugten Ausführungsform

Im Ausführungsbeispiel nach Figur 1 ist ein Elektronikschrank 1 mit einer Vielzahl von Elektronikeinschüben 2 ausgerüstet, wobei es sich bei einzelnen Elektronikeinschüben 2 auch um reine Elektroeinschübe handeln kann. Die Elektronikeinschübe 2 sind an einer Trennwand 3 gehaltert, die als Thermotrennwand ausgeführt ist, d.h. der Zuluftraum 4 ist gegenüber dem Elektronikraum 5 möglichst derart thermisch getrennt bzw. verbunden ist, dass eine Verbindung des Zuluftraumes 4 mit dem Elektronikraum 5 nur über Öffnungen im Bereich der Elektronikeinschübe 2 gegeben ist. D.h. umwälzende Raumluft 6 muss zwangsgeleitet durch die Elektronikeinschübe 2 hindurch strömen.

Der Verdampfer 7 einer externen Kälteanlage 8 ist im unteren Bereich des Elektronikschrankes 2 angeordnet. Der Verdampfer 7 ist über beispielsweise drei Lüfter 9, die in der Figur 1 hintereinander angeordnet sind, derart im Kreislauf der umwälzenden Raumluft 6 eingebunden, dass die durch die Elektronikeinschübe 2 hindurch umwälzende und dabei erwärmte Raumluft 6 auf der einen Seite in den Strömungskanal des als Lamellenkühler ausgeführten Verdampfers 7 einströmt und auf der anderen Seite als gekühlte Luft wieder ausströmt. Hinter den Lüftern 9 ist jeweils eine Rückschlagklappe 34 vorgesehen. Dadurch wird, z.B. auch bei Ausfall eines der Lüfter 9, verhindert, dass ein Teil der umwälzenden Raumluft 6 zurück in den Verdampfer 7 strömen kann.

Kältetechnisch ist der Verdampfer 7 mit der externen Kälteanlage 8 über eine Kältemittelvorlaufleitung 10 und eine Kältemittelrücklaufleitung 11 verbunden. Im Ausführungsbeispiel sind diese Leitungen in einem isolierten Kanal innerhalb des Fußbodens 12 verlegt. Die neben dem Verdampfer 7 zur Kälteanlage 8 gehörigen wesentlichen Baugruppen Verdichter 13 und Verflüssiger 14 befinden sich innerhalb der Figur 1 in der Position Kälteanlage 8. Die zwangsweise anfallende Abwärme 15 wird durch die Gebäudewand 16 ins Freie geleitet. Ein weiteres wesentliches Bauteil einer Kälteanlage ist das Ventil 24. Dieses ist in Figur 1 zugehörig zum Verdampfer 7 nicht näher dargestellt, sondern nur im Schaltschema nach Figur 2.

In Figur 2 ist das Schaltschema der erfindungsgemäßen Einrichtung dargestellt und wird nachfolgend näher beschrieben. Die Baugruppen Verdichter 13 und Verflüssiger 14 der Kälteanlage 8 sind in einer kompakten Einheit zusammengefasst. Zugehörig ist ein Lüfter 33 mit einem Drehzahlregler 19, ein Niederdruckschalter 20 vor dem Verdichter 13 und ein Hochdruckschalter 21 zwischen Verdichter 13 und Verflüssiger 14 sowie ein Kältemittelsammler 22.

Der innerhalb des Elektronikschrankes 1 angeordnete Verdampfer 7 ist beispielhaft in sechs Verdampfersegmente 7' unterteilt. Die Verbindung zwischen dem Kältemittelsammler 22 und dem Verdampfer 7 erfolgt über die Kältemittelvorlaufleitung 10 und die Kältemittelrücklaufleitung 11. In der Kältemittelvorlaufleitung 10 ist ein Handventil 23 und vor dem Verdampfer 7 ist ein Ventil 24 mit einer Betätigungseinrichtung 25 vorgesehen. Mit Bezug auf die sechs Verdampfersegmente 7' ist nach dem Ventil 24 ein Kältemittel-Verteiler 26 mit sechs Verteilerleitungen 17 vorhanden, deren Auslassöffnungen mit den parallelen Kältemittel-Eingangsöffnungen der sechs Verdampfersegmente 7' verbunden sind.

Die Kältemittelrücklaufleitung 11 verbindet die Kältemittel-Sammelleitung 18 mit dem Verdichter 13. Vor dem Verdichter 13 befindet sich ein Handventil 27 und der Niederdruckschalter 20.

Die räumliche Entfernung zwischen der Kälteanlage 8 und dem Elektronikschrank 1 mit dem Verdampfer 7 kann in der Praxis durchaus einige Meter betragen. Die kältetechnische Verbindung über handelsübliche Kältemittel-Rohrverbinder 28, die jeweils nahe der Baugruppen Kälteanlage 8 und Verdampfer 7 vorgesehen sind.

Neben der kältetechnischen Ausrüstung ist erfindungsgemäß eine digitale Regeleinheit 29 mit einem elektronischen Speicher für technologisch vorgegebenen Prozessdaten zur Regelung der Kühlleistung vorhanden. Die digitale Regeleinheit 29 ist mit einer Vielzahl von Signalgebern am Verdampfer 7 verbunden. Die Verbindungsleitungen sind in Figur 1 und 2 lediglich schematisch dargestellt und mit der Position Verbindungsleitung 30 gekennzeichnet.

Die Vielzahl von Signalgebern ist an die spezifischen Erfordernisse in der konkreten Anwendung angepasst. Im Ausführungsbeispiel sind mehrere Temperaturfühler insbesondere am Lufteintritt und am Luftaustritt des als Kühlkanal fungierenden Verdampfers 7, im Bereich des Kältemitteleinganges und des Kältemittelausganges sowie im mittleren Bereich des Verdampfers 7 vorgesehen. Von besonderer Bedeutung ist auch ein Taupunktfühler 32, der im oberen Bereich des Elektronikschrankes vorhanden ist und dessen Signalgeber ebenfalls mit der digitalen Regeleinheit 29 verbunden ist. Die digitale Regeleinheit 29 ist zur Übertragung spezifischer Öffnungsimpulse über die Verbindungsleitung 31 mit dem Ventil 24 der Betätigungseinrichtung 25 verbunden.

Die erfindungsgemäße Einrichtung wird nachfolgend beispielhaft unter Anwendung des erfindungsgemäßen Verfahrens näher beschrieben. Ein Elektronikschrank 1 mit den Elektronikeinschüben 2 der Größe 19 Zoll produziert im Betrieb eine Verlustleistung in Form von Wärme von ca. 7 kW. Das ist eine erhebliche Wärmemenge, die mit der erfindungsgemäßen Einrichtung und unter Anwendung des erfindungsgemäßen Verfahrens an die Außenluft abgeführt werden soll. Aufgabengemäß ist eine Kälteanlage 8 vorhanden, die eine Spitzenleistung von ca. 8 kW Kälteleistung gewährleistet.

Als Kühleinrichtung ist der Verdampfer 7 der Kälteanlage 8 innerhalb des Elektronikschrankes 1 angeordnet. Es werden die Temperaturen im Bereich des Kältemitteleinganges und des Kältemittelausganges sowie an einer Vielzahl von weiteren Punkten am Verdampfer 7, die Temperatur der umgewälzten Raumluft im Elektronikschrank 1 in Strömungsrichtung vor und hinter dem Verdampfer 7 sowie die aktuelle Taupunkttemperatur im oberen Bereich des Elektronikschrankes am Taupunktfühler 32 gemessen und die jeweiligen Messwertsignale der digitalen Regeleinheit 29 zugeführt. In der digitalen Regeleinheit 29 wird auf der Grundlage der technologisch vorgegebenen Prozessdaten sowie der Messwertsignale die aktuell erforderliche Kälteleistung ermittelt. Die dafür erforderliche Menge eines Kältemittels wird dem Verdampfer zugeführt, indem im Ergebnis der Rechenprozesse der digitalen Regeleinheit 29 das Ventil 24 der Betätigungseinrichtung 25 gesteuert wird, indem über die Verbindungsleitung 31 spezifische Öffnungsimpulse ausgegeben werden.

Beispielhaft wird die Kälteanlage 8 derart gesteuert, dass die mittlere Temperatur des Verdampfers 7 zwischen 10 und 12°C liegt. Die Temperatur der umgewälzten Raumluft im Elektronikschrank 1 kann damit im Elektronikraum 5 in einem Bereich unter 28°C gehalten werden, was für die meisten Einsatzgebiete völlig ausreichend ist. Die Wärme wird über den Kühlmittelkreislauf mit der Kältemittelrücklaufleitung 11 zur Kälteanlage 8 mit dem Verdichter 13 und Verflüssiger 14 über den Lüfter 33 an die Außenluft abgeführt.

### Liste der verwendeten Bezugszeichen

- 1: Elektronikschrank
- 2: Elektronikeinschub
- 3: Trennwand
- 4: Zuluftraum
- 5: Elektronikraum
- 6: umwälzende Raumluft
- 7: Verdampfer
- 7': Verdampfersegmente
- 8: Kälteanlage
- 9: Lüfter
- 10: Kältemittelvorlaufleitung
- 11: Kältemittelrücklaufleitung
- 12: Fußboden
- 13: Verdichter
- 14: Verflüssiger
- 15: Abwärme
- 16: Gebäudewand
- 17: Verteilerleitungen
- 18: Kältemittel-Sammelleitung
- 19: Drehzahlregler
- 20: Niederdruckschalter
- 21: Hochdruckschalter
- 22: Kältemittelsammler
- 23: Handventil
- 24: Ventil
- 25: Betätigungseinrichtung
- 26: Kältemittelverteiler
- 27: Handventil
- 28: Kältemittel-Rohrverbinder
- 29: digitale Regeleinheit
- 30: Verbindungsleitungen
- 31: Verbindungsleitung
- 32: Taupunktfühler
- 33: Lüfter
- 34: Rückschlagklappe

## Patentansprüche

1. Einrichtung zum Kühlen des Innenraums eines räumlich geschlossenen Elektronikschrankes (1) mit darin angeordnet mindestens einer elektronischen oder elektrischen Wärmequelle, mit mindestens einer Kühleinrichtung, bestehend aus einer Kälteanlage (8), deren verdichter (13) und Verflüssiger (14) außerhalb des Elektronikschrankes (1) angeordnet sind und der Verdampfer (7) innerhalb des Elektronikschrankes (1) vorgesehen ist, wobei der Verdampfer (7) mit dem Verdichter (13) und dem Verflüssiger (14) durch Kältemittelleitungen verbunden ist, sowie einer Vorrichtung zum Umwälzen der Raumluft, **dadurch gekennzeichnet, dass** der Verdampfer (7) von einem Kühlkanal umschlossen ist, derart dass die umgewälzte Raumluft des Elektronikschrankes (1) innerhalb des Kühlkanals unmittelbar mit den Kühlflächen des Verdampfers (7) in Berührung kommt, dass in der Kältemittelleitung zum Verdampfer (7) ein Ventil (24) mit einer Betätigungseinrichtung (25) angeordnet ist und dass verbunden mit der Betätigungseinrichtung (25) eine digitale Regeleinheit (29) zur Regelung der Kühlleistung vorhanden ist.

2. Einrichtung nach Anspruch 1, **dadurch gekennzeichnet, dass** am Ausgang des Kühlkanals um den Verdampfer (7) mindestens ein Lüfter (9) vorhanden und derart in den Kreislauf der umwälzenden Raumluft (6) eingebunden ist, dass diese aus dem Kühlkanal als gekühlte Luft ausströmt, durch die Elektronikeinschübe 2 hindurch strömt und danach als erwärmte Luft am Eingang des Kühlkanals wieder in den Kühlkanal einströmt, wobei dem Lüfter (9) in Strömungsrichtung nachgeordnet eine Rückschlagklappe (34) derart zugeordnet ist, derart dass die Raumluft (6) ausschließlich in der vorgesehenen Richtung strömen kann.

3. Einrichtung nach Anspruch 1 oder 2, **dadurch gekennzeichnet, dass** die digitale Regeleinheit (29) zur Regelung der Kühlleistung einen elektronischen Speicher für technologisch vorgegebene Prozessdaten aufweist und dass die digitale Regeleinheit (29) mit einer Vielzahl von Signalgebern am Verdampfer (7) verbunden ist.

4. Einrichtung nach Anspruch 1 oder 2, **dadurch gekennzeichnet, dass** der Verdampfer (7) in eine Vielzahl von Verdampfersegmenten (7') mit je einem Kältemitteleingang und je einem Kältemittelausgang unterteilt ist, dass zwischen dem Ventil (24) und dem Verdampfer (7) ein Kältemittelverteiler (26) mit einer entsprechenden Vielzahl von Verteilerleitungen (17) vorhanden ist, und dass jeder Kältemitteleingang mit je einer Verteilerleitung (17) verbunden ist.

5. Einrichtung nach Anspruch 4, **dadurch gekennzeichnet, dass** die Kältemittelausgänge der Verdampfersegmente (7') mit einer Kältemittel-Sammelleitung (18) verbunden sind.

6. Einrichtung nach einem der Ansprüche 1 bis 5, **dadurch gekennzeichnet, dass** am Lufteintritt und am Luftaustritt des Kühlkanals Temperaturmessfühler vorgesehen sind, deren Signalgeber mit der digitalen Regeleinheit (29) verbunden sind.

7. Einrichtung nach einem der Ansprüche 1 bis 6, **dadurch gekennzeichnet, dass** am Verdampfer (7) im Bereich des Kältemitteleinganges und des Kältemittelausganges sowie im mittleren Bereich des Verdampfers (7) Temperaturmessfühler vorhanden sind, deren Signalgeber mit der digitalen Regeleinheit (29) verbunden sind.

8. Einrichtung nach einem der Ansprüche 1 bis 7, **dadurch gekennzeichnet, dass** im oberen Bereich des Elektronikschrankes (1) ein Taupunktfühler (32) vorhanden ist, dessen Signalgeber mit der digitalen Regeleinheit (29) verbunden ist.

9. Verfahren zum Kühlen des Innenraums eines räumlich geschlossenen Elektronikschrankes (1) mit darin angeordneten elektronischen und/oder elektrischen Wärmequellen, wobei der Elektronikschrank (1) mindestens eine Kühleinrichtung, bestehend aus einer Kälteanlage (8), deren Verdichter (13) und Verflüssiger (14) außerhalb des Elektronikschrankes (1) und deren Verdampfer (7) innerhalb des Elektronikschrankes (1) vorgesehen ist, wobei der Verdampfer (7) mit dem Verdichter (13) und dem Verflüssiger (14) durch Kältemittelleitungen verbunden ist und in der Kältemittelleitung zum Verdampfer (7) ein Ventil (24) mit einer Betätigungseinrichtung (25) vorgesehen ist, einer Vorrichtung zum Umwälzen der Raumluft (6) und eine digitalen Regeleinheit (29) zur Regelung der Kühlleistung der Kühleinrichtung mit einem elektronischen Speicher für technologisch vorgegebenen Prozessdaten, bei dem die Temperatur im Bereich des Kältemitteleinganges und des Kältemittelausganges sowie an einer Vielzahl von weiteren Punkten am Verdampfer (7), und/oder die Temperatur der umgewälzten Raumluft im Elektronikschrank (1) in Strömungsrichtung vor und hinter dem Verdampfer (7) und/oder die aktuelle Taupunkttemperatur im oberen Bereich des Elektronikschrankes (1) gemessen werden und die jeweiligen Messwertsignale der digitalen Regeleinheit (29) zugeführt werden, dass in der Regeleinheit (29) auf der Grundlage der technologisch vorgegebene Prozessdaten sowie der Messwertsignale die aktuell erforderliche Kälteleistung ermittelt wird und das die Betätigungseinrichtung (25) am Ventil (24) derart gesteuert wird, dass die erforderliche Menge eines Kältemittels dem Verdampfer (7) zugeführt wird.
